(19) **Europäisches Patentamt**
**European Patent Office**
**Office européen des brevets**

(11) Veröffentlichungsnummer: **0 017 244**
A1

(12) # EUROPÄISCHE PATENTANMELDUNG

(21) Anmeldenummer: **80101821.9**

(22) Anmeldetag: **03.04.80**

(51) Int. Cl.³: **H 01 L 27/10**
**H 04 N 3/14, G 06 G 7/19**
**G 06 F 15/336**

(30) Priorität: **10.04.79 DE 2914517**

(43) Veröffentlichungstag der Anmeldung:
**15.10.80 Patentblatt 80/21**

(84) Benannte Vertragsstaaten:
**FR GB**

(71) Anmelder: **SIEMENS AKTIENGESELLSCHAFT Berlin
und München**
**Postfach 22 02 61**
**D-8000 München 22(DE)**

(72) Erfinder: **Bardl, Artur, Ing. grad.**
**Grabmannstrasse 21**
**D-8000 München 71(DE)**

(54) **Halbleiterschaltung mit taktgesteuerten Ladungsverschiebungsanlagen.**

(57) Wie gemäß der Erfindung erkannt wurde, ist es für verschiedene Aufgaben vor allem auf optischem Gebiet von Bedeutung, wenn die in zwei auf demselben Halbleiterkristall integrierten taktgesteuerten Ladungsverschiebungsanlagen ($CCD_1$, $CCD_2$) erzeugten Informationen zellenweise verglichen und ein der jeweiligen Differenz der Informationen zweier jeweils einander zugeordneter Zellen entsprechende Ausgangssignal erhalten wird sig.

FIG 1

CO17244

SIEMENS AKTIENGESELLSCHAFT    Unser Zeichen
Berlin und München          VPA
                            79 P 1 0 5 8 EUR

Halbleiterschaltung mit taktgesteuerten Ladungsverschiebungsanlagen

Die Erfindung betrifft eine Halbleiterschaltung mit
taktgesteuerten Ladungsverschiebungsanlagen.

Ladungsverschiebungsanlagen auf Halbleiterbasis sind
bekannt. Sie werden gewöhnlich als CCD-Anlagen bezeichnet und bestehen aus einer Anzahl von in einem Siliciumkristall in kleinen Abständen hintereinander angeordneten MOS-Dioden, die den p-leitenden oder n-leitenden Siliciumkristall als eine gemeinsame "Elektrode",
eine die Oberfläche des Siliciumkristalls bedeckende,
insbesondere aus $SiO_2$ bestehende Isolierschicht als
gemeinsames Dielektrikum und je eine auf der Isolierschicht aufsitzende Elektrode (Gate) als eine zweite
Elektrode aufweisen. Hinsichtlich der Taktversorgung
sind die hintereinander angeordneten Elektroden der
CCD-Anlage im Wechsel an mehrere vorhandene Taktversorgungsleitungen angeschlossen, so daß bei n vorgesehenen Taktversorgungsleitungen die erste, die (n+1)-
te, die (2n+1)te usw. Elektrode in der Reihenfolge

Stg 1 EM/5.4.1979

BAD ORIGINAL

an eine erste Taktversorgungsleitung, die zweite, die (n+2)te usw. Elektrode an eine zweite Taktversorgungsleitung, die dritte, die (n+3)te usw. Elektrode an eine dritte Taktversorgungsleitung angeschlossen ist, so daß der m-ten Taktleitung nach Maßgabe der Reihenfolge der einzelnen Kondensatorelektroden die m-te, die (n+m)te, die 2n+m)te Elektrode usw. zugeordnet ist. Die einzelnen Taktversorgungsleitungen werden mit periodischen Digitalimpulsen versorgt, wobei die verschiedenen Versorgungsleitungen mit derselben Frequenz aber zueinander phasenverschoben beaufschlagt werden. Eine erste Elektrode dient gewissermaßen als Source und eine letzte Elektrode als Drain, die sich von den übrigen Elektroden dadurch unterscheiden, daß sie unmittelbaren Kontakt mit dem Siliciumkristall haben. Sie können in Analogie zu einem MOS-Feldeffekttransistor über eine entgegengesetzt zu dem unter den Gateelektroden befindlichen Teil des Halbleiterkristalls dotierten Source- bzw. Drainbereich mit der sich unter den Gateelektroden befindlichen Kanalzone in Interaktion gebracht werden.

Die Anwendungsmöglichkeit solcher CCD-Anlagen liegen z.B. auf dem Gebiet der analogen Signalverarbeitung, auf dem Gebiet der dynamischen Speicher und auf dem Gebiet der optoelektronischen Bildwandlung.

Es ist Aufgabe der Erfindung, eine Halbleiterschaltung der genannten Art anzugeben, welche vor allem auf dem Gebiet der optoelektronischen Bildwandlung liegt und die u.a. auch die Korrelation von Bildmustern ermöglicht.

Erfindungsgemäß wird hierzu eine Halbleiterschaltung mit taktgesteuerten Ladungsverschiebungsanlagen vorgeschlagen, welche dadurch gekennzeichnet ist, daß mindestens zwei einander gleiche Ladungsverschiebungs- anlagen vorgesehen sind, daß dabei jede Speicherzelle der einen Ladungsverschiebungsanlage je einer Speicherzelle der anderen Ladungsverschiebungsanlage zugeordnet ist, daß hierzu der jeweilige Informationsinhalt der Speicherzellen der einen Ladungsverschiebungsanlage - z.B. in invertiertem Zustand - auf den Informationsinhalt der jeweils zugeordneten Speicherzelle der anderen Ladungsverschiebungsanlage übertragbar ist, und daß schließlich die infolge des Übertragungsvorganges erhaltenen neuen Informationen über eine Ladungsverschiebungsanlage seriell auslesbar sind. Insbesondere ist dabei vorgesehen, daß die Zuordnung der Speicherzellen der beiden Ladungsverschiebungsanlagen nach Maßgabe der geometrischen Reihenfolge der Speicherzellen in den Ladungsverschiebungsanlagen getroffen ist, was vor allem im Interesse der Korrelation optischer Muster, des Vergleichs von Helligkeits- bzw. Farbunterschieden usw. von Bedeutung ist.

Man kann nun in der ersten Ladungsverschiebungsanlage eine zu testende Informationsverteilung, z.B. durch serielle Einspeisung oder durch gleichzeitige unterschiedliche Belichtung der Halbleiteroberfläche im Bereich dieser Ladungsverschiebungsanlage erzeugen, die dann mit Hilfe der Vorrichtung gemäß der Erfindung auszuwerten ist. Ebenso wird in der zweiten Ladungsverschiebungsanlage eine zweite Informationsverteilung erzeugt, die mit der Informationsverteilung in der ersten CCD-Anlage zu vergleichen ist. Dies geschieht, indem der Informationsgehalt je einer der beiden jeweils zu vergleichenden und je einer der beiden Ladungsverschiebungsanordnungen angehörenden Speicherzellen durch eine entsprechende Transformation invertiert und dann mit dem nicht invertierten Inhalt der anderen Speicherzelle verglichen wird. Die aus dem jeweiligen Vergleich resultierende Information wird entweder über eine der beiden Ladungsverschiebungsanlagen und/oder über eine dritte – insbesondere bezüglich der Anzahl an Speicherzellen der ersten und der zweiten Ladungsverschiebungsanlage gleichen oder gar überlegenen weiteren Ladungsverschiebungsanordnung seriell ausgelesen.

Bevorzugt wird dabei folgende, sich auf die Korrelation von Mustern beziehende Sachlage ausgenutzt.

Unter Zuhilfenahme der bekannten Eigenschaften von CCD-Anlagen, die es erlauben eine dreidimensionale Informationsdarstellung auf engem Raum durchzuführen, ist es möglich, zwei Muster miteinander zu vergleichen, um Übereinstimmungskoeffizienten zu erhalten. Aufgrund der Koeffizienten ist es dann möglich, Bild oder Muster solange zu verschieben, bis Deckungsgleichheit erreicht ist. Die Korrelation ist nicht nur auf Konturen oder Schwarz-Weiß-Kontraste beschränkt, sondern kann auch unterschiedlich abgestufte Grauwerte erfassen, so daß auch – wenigstens in beschränktem Maße – die Auswertung von Farbunterschieden möglich ist. Bevorzugt erfolgt die Auswertung mit konstant bleibender Arbeitsgeschwindigkeit. Bei Zusammenschaltung von lichtempfindlichen Ladungserzeugern (CID) und Korrelations-CCD's auf einem MOS-Chip ist eine Einheit mit den Eigenschaften eines Auges möglich. Der Vergleich von Bildern, die z.B. aus 256 x 256 Bildpunkten zusammengesetzt sind, kann im Millisekundenbereich durchgeführt werden. Die Korrelationsgenauigkeit wird durch eine entsprechende Vorbereitung des optischen Bildes oder Musters (Veränderung der Hüllkurven) und durch das verwendete Vergleichsprinzip (Einzelbewertung der Bildpunkte oder Zeilen- bzw. Blockbeurteilung) bestimmt. Die mit den zur Zeit zur Verfügung stehenden Mitteln erreichbare Fehlerquote für den einzelnen Bildpunkt liegt unterhalb von 6%.

Zur Bildaufnahme können alle bekannten Verfahren herangezogen werden. Als Beispiele sind elektromagnetische Abtastungen, magnetische Abtastungen, sequentielle Abtastungen, zeilenweise Abtastungen, Abtastungen mit CID-Sensoren (= optische CCD-Anlagen) usw. verwendet worden. Erforderlich ist in allen Fällen, daß bei Anwendung auf die Korrelation von Mustern die verwendete Abtastart in ihrer Sequenz mit der Ausgabesequenz der Musterarten aus dem Musterspeicher übereinstimmt.

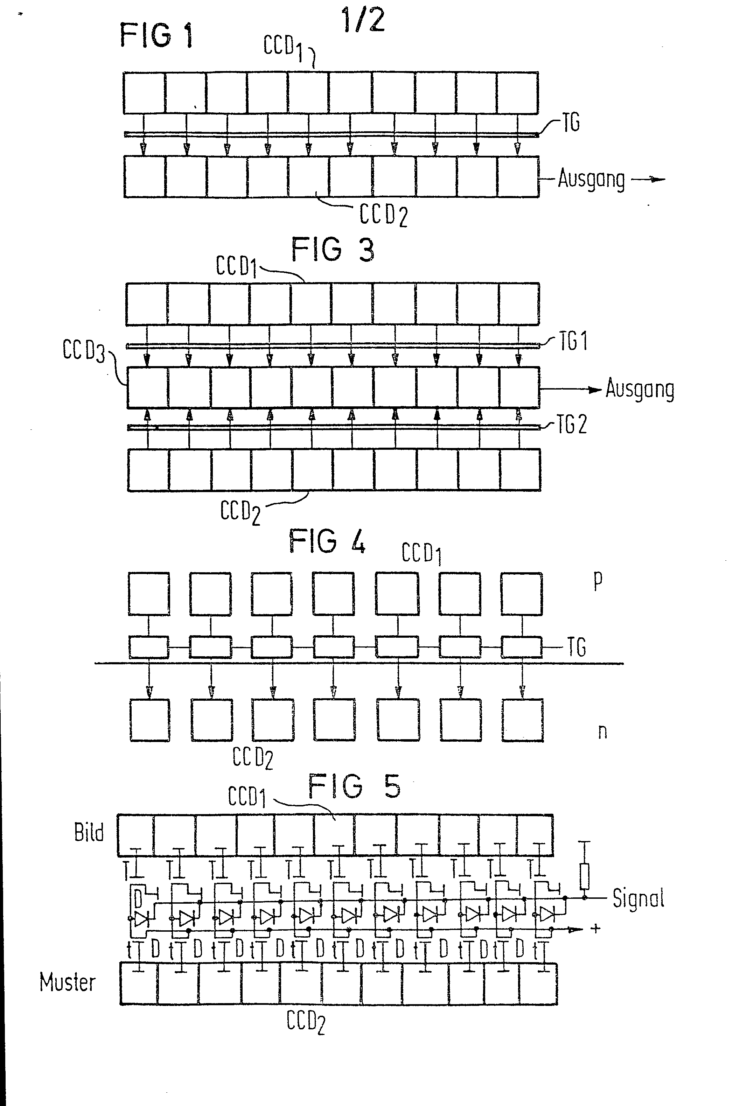

In Fig. 1 ist ein Beispiel für die Bildaufnahme mit einem CID dargestellt, wobei nur eine CID-Zeile vorhanden ist. In dem in Fig. 1 gezeigten Beispielsfall sind zwischen den einzelnen Zellen des optisch zu beaufschlagenden CID und den zugehörigen Zellen des die Vergleichsinformation führenden CCD's je eine durch einen Übertragungstakt gesteuerter Ladungsübergabe vom CID zum CCD vorgesehen. Die im CCD z.B. durch serielle Eingabe erzeugte und in invertierter Form vorliegende Vergleichsinformation erhält aufgrund der Informationsübertragung aus dem CID in den einzelnen Zellen die gewünschte Vergleichsinformation, die dann seriell, z.B. über einen Multiplexer zu einem Korrelator übertragen wird.

Andererseits kann man sich auch für das gesamte Bildformat eine dieses zeilenweise überdeckende Anzahl von solchen Anlagen gem. Fig. 1 vorstellen. Sind nach der vorgesehenen Belichtungszeit eine ausreichende Menge von Ladungsträgern erzeugt worden, so werden diese über das Transfergate aus dem jeweiligen CID in das zugeordnete CCD umgeladen. Dort spielt sich nun der Korrelationsprozeß ab. Der Nachteil bei diesem Verfahren ist eine zwangsweise ungleiche Behandlung der Ladungen, da die durch Licht erzeugten Ladungspakete einen Parallelweg zur Korrelation durchlaufen, während das Muster sequentiell eingegeben wird und die Ladungspakete unterschiedlich großen Transportverlusten unterworfen sind. Durch kontinuierliches Verkleinern der Eingangsverstärkung während des Einlesens können die Transportverluste ausgeglichen werden.

Es können drei Arten von Korrelation durchgeführt werden:

1) Kontinuierliche Korrelation
2) Korrelation entweder in dem die Bildinformation oder in dem die Musterinformation aufnehmenden CCD.
3) Korrelation in einem zwischen Bild- und Muster-CCD liegenden dritten CCD.

Bei jeder dieser Korrelationsarten werden die in den einzelnen CCD-Speicherzellen gespeicherten Ladungspakete von Bild und Muster addiert, wobei Bild und Muster zueinander invertiert sind. Das Muster, das als digitales Bild gespeichert sein kann, benötigt zur Korrelation eine bestimmte Vorbearbeitung.

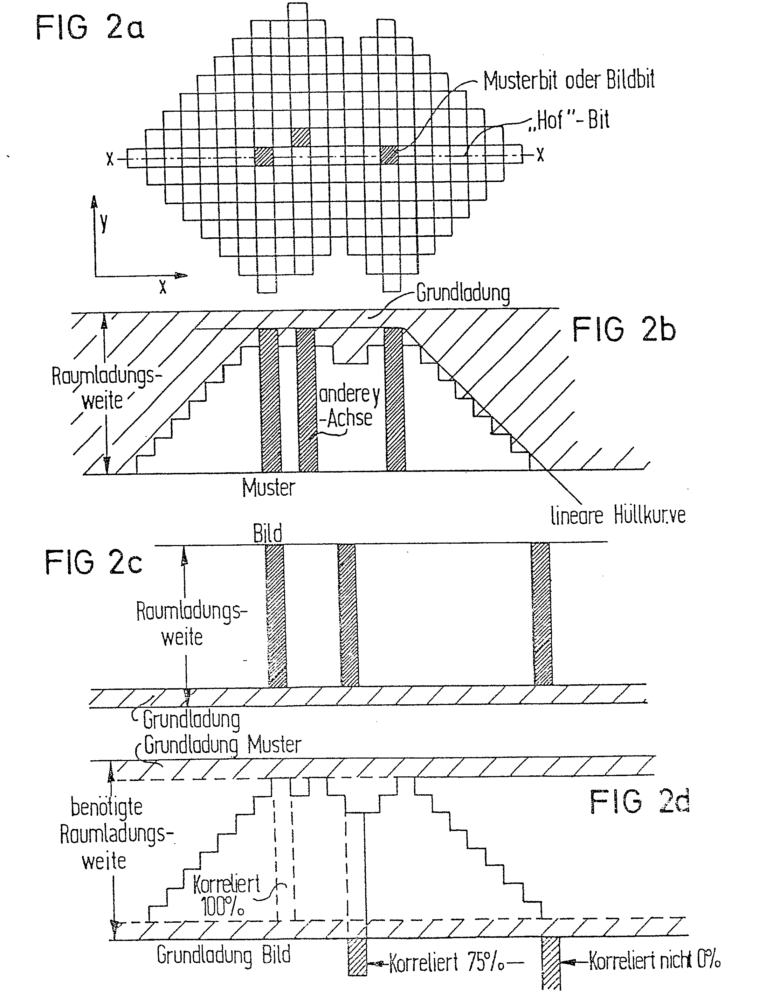

Um dies verständlich zu machen, wird der Einfachheit halber angenommen, daß alle Musterpunkte eine gleiche Spannungshöhe P besitzen und wird ferner angenommen, daß alle Bildpunkte ebenfalls diese Spannungshöhe P besitzen, dann ist die Übereinstimmung von Bild und dem invertierten Muster gegeben, wenn die Addition den Wert 0 ergibt. Im Beispielsfall wird angenommen, daß P gleich 8 Spannungseinheiten ist. Dieses Beispiel ist der Darstellung gemäß Fig. 2 zugrunde gelegt.

Diese Figur stellt eine Draufsicht auf die Anordnungen von CCD-Zeilen dar. Dabei ist die Spannungshöhe der Musterpunkte nicht angegeben. Um einen Korrelationswert von Muster und Bild zu erhalten, erzeugt man un

einen Bildpunkt oder Musterpunkt einen sogenannten Hof. Dieser Hof ist im Beispielsfalle von dem genannten Spannungswert P (im Beispiel 8 Spannungseinheiten) herab abgestuften Spannungswerten gegeben, deren Hüllkurve den Korrelationsfaktor bestimmt. Dies ist in Fig. 2b mit der in Fig. 2a gekennzeichneten Zeile dargestellt, die mit X-X' bezeichnet ist.

Die Fig. 2c stellt die Zeile mit dem zu vergleichenden Bildinhalt dar. Der Bildinhalt besteht aus drei Bildpunkten mit der Spannungshöhe P. Diese Zeile wird der Musterzeile benachbart angeordnet, da auf diese Weise aufwendige leitende Verbindungen in der Gesamtschaltung entbehrlich gemacht werden können.

Fig. 2d zeigt den Informationsgehalt nach dem Zusammenfließen der Ladungen aus der Musterzeile und der Bildzeile, wobei das Muster im Gegensatz zum Bild invertiert ist. In Fig. 2d ist angegeben, mit welchem Prozentsatz die Bildpunkte mit den Musterpunkten übereinstimmen.

Einsichtlich des Begriffes der Invertierung ist im Zusammenhang mit den vorliegenden Ausführungen folgendes festzustellen.

Im Muster ist die Spannungshöhe P durch die Ladung NULL definiert, während im Bild die Spannungshöhe P mit dem Ladungsmaximum definiert ist. Unter Anwendung dieser beiden Definitionen entsteht bei einer Übereinstimmung zwischen Muster und Bild kein Signal, wenn der Inhalt der einzelnen Bildzellen mit dem Inhalt der jeweils zugeordneten Musterzelle korrelliert wird.

Wie bereits angedeutet, ist die Musterinformation in einem mit der Anlage verbundenen Speicher festgehalten und kann beliebig oft abgerufen werden. Dabei empfiehlt es sich, die Musterinformation einschließlich des Hofes um den jeweiligen Musterpunkt bereits in invertiertem Zustand einzuspeichern.

Bei Nichtübereinstimmung von Muster und Bild entsteht über das Signal des Musters hinaus eine Erhöhung der Spannung durch die Ladung des Bildpunktes. Diese Spannungserhöhung bildet ein Maß für Nichtübereinstimmung. Nur dieses Nichtübereinstimmungssignal wird für die Auswertung herangezogen.

Bei der in Fig. 1 schematisch dargestellten Vorrichtung hat man eine erste optisch zu beaufschlagende CCD-Anlage CID und eine zweite mit der invertierten Musterinformation zu beaufschlagende CCD-Anlage CCD und zwischen den beiden ein die Ladungsübertragung bei Einsetzen eines Hilfstaktes vom CID zu dem CCD auslösendes Transfergate, das durch eine in analoger Weise wie die Elektroden der CCD-Anlage ausgestaltete und durch den Hilfstakt zu beaufschlagende Gateelektrode gegeben ist. Die durch die Übertragung in der Ladungsverschiebungsanlage CCD erhaltene Information wird seriell ausgelesen und verwertet.

Handelt es sich um die Erzeugung der Differenzsignale zwischen den Informationen von CID und CCD, dann muß die für den Vergleich heranzuziehende Musterinformation in der Anlage CCD in invertierter Form vorliegen, wie dies bereits wiederholt festgestellt worden ist. Die Musterinformation kann z.B. einem mit der Gesamtschaltung monolithisch vereinigten Speicher, insbesondere einem entsprechend ausgestalteten oder programmierten Festwertspeicher, entnommen werden, in dem die Musterinformation bereits in der erforderlichen invertierten Form eingespeichert ist.

Anderenfalls kann man, insbesondere bei optischer
Beaufschlagung auch der Vergleichsanlage, die in diesem aufgenommene Vergleichsinformation seriell auslesen und über einen mit der Schaltung vereinigten Inverter in das in der in Fig. 1 dargestellte Anlage vorgesehene Vergleichs-CCD oder bei einer entsprechend _
Fig. 3 dargestellten Anlage in eine dritte, das bei
dem Vergleich der aus zwei CCD-Anlagen $CCD_1$ und $CCD_2$
entstehende Ergebnis aufnehmende CCD-Anlage $CCD_3$ übertragen. In diesem Falle bildet dann der Signalausgang
der dritten CCD-Anlage $CCD_3$ den Signalausgang der Gesamtanlage, über welchen die aufgrund des Vergleichs
erhaltene Information zur Vergügung gestellt wird.

Es besteht die Möglichkeit, zwischen den beiden CCD-
Einrichtungen eine in der Skizze gezeigte Transistoranordnung anzuordnen. Die Gates der Transistoren werden über sogenannte Floatinggates oder Floatingdiffusionsanschlüsse gesteuert. Zusätzliche nötige Einrichtungen zum Einstellen der Arbeitspunkte bei der Floatinggateausführung sind nicht dargestellt. Den Transistorgates wird, ohne die in den CCD's liegende Ladung
zu zerstöfen, der Ladungszustand in der CCD-Zelle eingeprägt, so daß Muster und Bild aneinander vorbeigeschoben werden können, ohne beides immer wieder neu
einzulesen. Bei dieser Anordnung entsteht ein Signal
immer dann, wenn Übereinstimmungen auftreten. Je größer
die Übereinstimmung, desto größer das Signal.

Die in Fig. 5 dargestellte und nach den soeben gebrachten Gesichtspunkten aufgebauten Anlage gemäß der Erfindung besteht aus den beiden monolithisch vereinigten
und - außerhalb den eigentlichen Vergleichsphasen -
durch dieselben Taktfolgen gesteuerten CCD-Anlagen
$CCD_1$ und $CCD_2$. Zwischen jeweils zwei einander zugeordneten Zellen von $CCD_1$ und $CCD_2$ ist jeweils eine aus
zwei MOS-Feldeffekttransistoren T und t und eine Diode

BAD ORIGINAL

0017244

0    VPA    79 P 1 0 5 8 EUR

D bestehende, die Bildung der jeweiligen Informationsdifferenz ermöglichende Schaltung vorgesehen. Die
Transistoren T und t sind bevorzugt vom Anreicherungstyp, die in dem zugleich die beiden CCD-Anlagen aufnehmenden und z.B. aus p-leitendem Silicium bestehenden einkristallinen Substrat erzeugt sind. Der eine
stromführende Anschluß jedes der Transistoren T liegt
an Masse, der andere an je einem Knoten, der einerseits
mit der Kathode der Diode D, andererseits über die
Source-Drainstrecke des jeweils zugehörigen Transistors
t mit einem zweiten Betriebspotential, z.B. einem positiven Potential gegenüber Masse, verbunden ist. Die Anoden
der Dioden D bilden zusammen den Signalausgang.

Für die Steuerung der Gates der einzelnen Transistoren
T und t sind diese entweder sperrfrei oder kapazitiv
mit dem ihnen jeweils zugeordneten und die CCD-Ladung
der betreffenden CCD-Zelle führenden Halbleitergebiet
gekoppelt. Im Falle der kapazitiven Kopplung kann die
kapazitive Kopplung über je ein der betreffenden CCD-
Zelle zugeordnetes floating Gate erfolgen.

Es besteht die Möglichkeit, entsprechend Fig. 4 zwischen den beiden CCD-Anlagen $CCD_1$ und $CCD_2$ einen pn-
Übergang vorzusehen, der in Sperrichtung gepolt lediglich einen von Minoritätsträgern getragenen Sperrstrom
erlaubt. Da die in den einzelnen CCD-Anlagen $CCD_1$ und
$CCD_2$ transportierten Ladungen aus den Minoritätsträgern
des betreffenden Halbleiterbereiches bestehen, ist die
Möglichkeit gegeben, bei geeigneter Ausgestaltung der
Taktversorgung mittels der Transfergatter TG die Ladung vom $CCD_1$ auf die entsprechenden Zellen von $CCD_2$
zu übertragen. Da die beiden Ladungen vom entgegengesetzten Typ sind, würde sich dann im $CCD_2$ die Differenzinformation in Gestalt einer elektrischen und über das
betreffende CCD auswertbaren Ladung einstellen.

5 Figuren

10 Patentansprüche

BAD ORIGINAL

11    VPA                     79 P 1 0 5 8 EUR

Patentansprüche

1. Halbleiterschaltung mit taktgesteuerten Ladungsverschiebungsanlagen, d a d u r c h   g e k e n n -
z e i c h n e t, daß mindestens zwei einander gleiche
Ladungsverschiebungsanlagen vorgesehen sind, daß dabei
jede Speicherzelle der einen Ladungsverschiebungsanlage je einer Speicherzelle der anderen Ladungsverschiebungsanlage zugeordnet ist, daß hierzu der jeweilige
Informationsinhalt der einen Ladungsverschiebungsanlage auf den Informationsinhalt der jeweils zugeordneten Speicherzelle der anderen Ladungsverschiebungsanlage übertragbar ist, und daß schließlich die infolge des Übertragungsvorganges erhaltenen neuen Informationen über eine gemeinsame Ladungsverschiebungsanlage seriell auslesbar sind.

2. Halbleiterschaltung nach Anspruch 1, d a d u r c h
g e k e n n z e i c h n e t, daß wenigstens eine der
beiden die zu kombinierenden Informationen führenden
Ladungsverschiebungsanlagen ihre Informationen aufgrund einer optischen Beaufschlagung ihrer als CID-
Zellen ausgebildeten Speicherzellen erhält.

3. Halbleiterschaltung nach Anspruch 1 oder 2, d a -
d u r c h   g e k e n n z e i c h n e t, daß die in
der einen der Ladungsverschiebungsanlagen gespeicherte Information in invertiertem Zustand auf die in der
anderen Ladungsverschiebungsanlage gespeicherte Information übertragbar ist.

4. Halbleiterschaltung nach Anspruch 3, d a d u r c h
g e k e n n z e i c h n e t, daß die in der einen
Ladungsverschiebungsanlage gespeicherte Information
nach serieller Auslesung über einen Inverter in eine
zweite Ladungsverschiebungsanlage gelangt.

5. Halbleiterschaltung nach Anspruch 3 oder 4, d a d u r c h   g e k e n n z e i c h n e t, daß die zu kombinierenden Informationen enthaltenden Ladungsverschiebungsanlagen in je einem von zwei in einem Halbleiterkristall vereinigten Bereichen vom entgegengesetzten Leitungstyp erzeugt sind und daß die in der einen der beiden Ladungsverschiebungsanlagen gespeicherte Information über den zwischen den beiden Bereichen liegenden pn-Übergang auf wenigstens eine Speicherzelle der anderen Ladungsverschiebungsanlage in Form von den pn-Übergang passierenden elektrischen Ladungen - insbesondere taktgesteuert - übertragbar ist.

6. Halbleiterschaltung nach den Ansprüchen 1 bis 5, d a d u r c h   g e k e n n z e i c h n e t, daß die eine der beiden taktgesteuerten Ladungsverschiebungsanlagen durch die in einem mit der Schaltung vereinigten Speicher, insbesondere Festwertspeicher, enthaltenen Muster- oder Standartinformationen über einen Inverter und die andere der beiden taktgesteuerten Ladungsverschiebungsanlagen optisch beaufschlagbar ist.

7. Halbleiterschaltung nach den Ansprüchen 1 bis 6, d a d u r c h   g e k e n n z e i c h n e t, daß die zu kombinierenden Informationen der beiden Ladungsverschiebungsanlagen auf eine dritte Ladungsverschiebungsanlage im Parallelbetrieb übertragbar sind.

8. Halbleiterschaltung nach den Ansprüchen 1 bis 7, d a d u r c h   g e k e n n z e i c h n e t, daß für die serielle Weitergabe der Informationen in den einzelnen Ladungsverschiebungsanlagen ein für alle in der Schaltung vorgesehenen Ladungsverschiebungsanlagen gemeinsamer erster Taktgeber und für die Parallelübertragung von Information aus einer ersten Ladungsverschiebungsanlage in eine zweite Ladungsverschiebungsanlage ein zweiter Taktgeber vorgesehen ist.

9. Ealbleiterschaltung nach den Ansprüchen 1 bis 8,
d a d u r c h   g e k e n n z e i c h n e t, daß die
Gesamtheit der vorgesehenen Ladungsverschiebungsanlagen
in Form von parallelen Zeilen an der Oberfläche des die
Ealbleiterschaltung aufnehmenden Halbleiterkristalls,
insbesondere Siliciumkristalls, geführt sind.

10. Ealbleiterschaltung nach den Ansprüchen 1 bis 9,
d a d u r c h   g e k e n n z e i c h n e t, daß zwischen den jeweils einander zugeordneten Zellen der beiden Ladungsverschiebungsanlagen ($CCD_1$, $CCD_2$) jeweils
eine aus zwei Feldeffekttransistoren (T, t) und einer
Diode (D) bestehende und den Vergleich der in den beiden Zellen vorliegenden Informationen ermöglichende
Vergleichsschaltung vorgesehen ist (Fig. 5).

FIG 1

CCD₁

TG

Ausgang →

CCD₂

FIG 3

CCD₁

TG1

CCD₃

Ausgang

TG2

CCD₂

FIG 4

CCD₁

p

TG

n

CCD₂

FIG 5

CCD₁

Bild

Signal

+

Muster

CCD₂

FIG 2a

Musterbit oder Bildbit

„Hof"-Bit

x —— x

y

X

Grundladung

FIG 2b

Raumladungsweite

andere y
-Achse

lineare Hüllkurve

Muster

Bild

FIG 2c

Raumladungsweite

Grundladung

Grundladung Muster

benötigte
Raumladungsweite

FIG 2d

Korreliert
100%

Grundladung Bild

Korreliert 75%—

Korreliert nicht 0%

Europäisches
Patentamt

**EUROPÄISCHER RECHERCHENBERICHT**

Nummer der Anmeldung

EP 80 10 1821

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | RCA REVIEW, Band 35, No. 3, September 1974, Princeton, US, P.K. WEIMER et al.: "Video processing in charge-transfer image sensors by recycling of signals through the sensor", Seiten 341-354<br><br>* Seiten 342-346 "General description of video recycling in image sensors" *<br><br>-- | 1-4 |
| | "3rd INTERNATIONAL CONFERENCE ON Charge Coupled Devices", September 1976, Edinburgh, GB, I. LAGNADO et al.: "A CCD analog and digital correlator", Seiten 238-258<br><br>* Bild 2 *<br><br>-- | 1,20 |
| A | US - A - 4 064 533 (D.R. LAMPE et al.)<br><br>* Ansprüche; Bild 3 *<br><br>-- | 1 |
| A | ELECTRONICS, Band 50, Nr. 7, 31. März 1977, New York, US, T.A. ZIMMERMAN et al.: "A new role for charge-coupled devices: digital signal processing", Seiten 97-103<br><br>* Bild 7 *<br><br>---- | 1 |

**KLASSIFIKATION DER ANMELDUNG (Int.Cl 3)**

H 01 L 27/10
H 04 N 3/14
G 06 G 7/19
G 06 F 15/336

**RECHERCHIERTE SACHGEBIETE (Int Cl 3)**

H 01 L 27/10
H 04 N 3/14
G 06 G 7/19
G 06 F 15/336
H 01 L 27/14

**KATEGORIE DER GENANNTEN DOKUMENTE**

X von besonderer Bedeutung
A technologischer Hintergrund
O nichtschriftliche Offenbarung
P Zwischenliteratur
T der Erfindung zugrunde liegende Theorien oder Grundsätze
E kollidierende Anmeldung
D in der Anmeldung angeführtes Dokument
L aus andern Gründen angeführtes Dokument
& Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Den Haag | 04-07-1980 | CARDON |